# EUROPEAN PATENT APPLICATION

(11) **EP 3 340 404 A1**
(43) Date of publication of application: **27.06.2018**
(21) Application number: 16836866.0
(22) Date of filing: 17.06.2016
(51) Int. Cl.: H01S 5/022

(54) **LIGHT EMITTING DEVICE**

(30) Priority: 18.08.2015 JP 2015161163
(71) Applicant: Alps Electric Co., Ltd., Tokyo 145-8501 (JP)
(72) Inventor: KIKUCHI, Toshihiro, Tokyo 145-8501 (JP); KAMEDA, Hiroshi, Tokyo 145-8501 (JP)
(74) Representative: Schmitt-Nilson Schraud Waibel Wohlfrom Patentanwälte Partnerschaft mbB
(86) International application number: PCT/JP2016/068148
(87) International publication number: WO 2017/029874

(57) **Abstract**

Provide a light-emitting device capable of condensing laser light rays output from a plurality of light sources to be a spot whose diameter is less than or equal to a predetermined size to increase a light intensity per unit area.

A light-emitting device includes a light source unit including a plurality of laser light sources; a dioptric system that refracts each light ray input from each of the plurality of laser light sources; a condensing optical system that condenses a plurality of refracted light rays input from the dioptric system, respectively, wherein the dioptric system is configured to refract a plurality of center light beams that are output along optical axes of the plurality of laser light sources, respectively, to proceed in directions each departing from an optical axis of the condensing optical system as proceeding toward the condensing optical system.

## Description

### BACKGROUND OF THE INVENTION

### 1. Field of the Invention

The present invention relates to a light-emitting device including a plurality of laser light sources.

### 2. Description of the Related Art

Patent Document 1 discloses a laser module in which diverging light rays output from a plurality of semiconductor laser elements are made to be parallel light rays by a collimator lens, and the parallel light rays are condensed by a condenser lens. Patent Document 2 discloses a semiconductor laser device in which light rays output from a plurality of laser diodes are made to be parallel light rays by a collimator lens, and the parallel light rays are condensed by a condenser lens into an optical fiber.
Patent Document 1: Japanese Laid-open Patent Publication No. 2006-66875
Patent Document 2: Japanese Laid-open Patent Publication No. 2013-251394

For a so-called CAN laser which is packaged by inserting a laser diode in a metal can, embodiments in which a plurality of laser diodes are inserted are becoming to be used for actualizing high-power. However, according to the conventional CAN laser, optical axes of a plurality of semiconductor laser elements or a plurality of laser diodes are provided to be in parallel to an optical axis of a condenser lens, as described as the laser module of Patent Document 1 or the semiconductor laser device of Patent Document 2. Thus, even when the laser light rays output from these light sources are condensed by the condenser lens, because a plurality of spots may exist, or even if a single spot is formed, the diameter of which may be large and may not be sufficiently converged, it was difficult to provide light of a desired high intensity on a small irradiation target.

### SUMMARY OF THE INVENTION

The present invention is made in light of the above problems, and provides a light-emitting device capable of condensing laser light rays output from a plurality of light sources to be a spot whose diameter is less than or equal to a predetermined size to increase a light intensity per unit area.

According to the invention, there is provided a light-emitting device including a light source unit including a plurality of laser light sources; a dioptric system that refracts each light ray input from each of the plurality of laser light sources; a condensing optical system that condenses a plurality of refracted light rays input from the dioptric system, respectively, wherein the dioptric system is configured to refract a plurality of center light beams that are output along optical axes of the plurality of laser light sources, respectively, to proceed in directions each departing from an optical axis of the condensing optical system as proceeding toward the condensing optical system.

With this configuration, a plurality of converging light rays output from the condensing optical system can be overlapped and condensed to be a small spot, and light with a high light intensity per unit area can be obtained.

In the light-emitting device of the invention, it is preferable that the dioptric system includes a plurality of inclined surfaces each having an inclined angle corresponding to each of the plurality of laser light sources.

With this, as reflected light rays can be output from the dioptric system to the condensing optical system with desired angles by inclined surfaces corresponding to an arrangement or the like of the plurality of laser light sources with respect to the optical axis of the condensing optical system, the plurality of converging light rays can be condensed to be a small spot.

In the light-emitting device of the invention, it is preferable that the plurality of inclined surfaces are provided at at least one of an incident surface and a light exiting surface of the dioptric system.

With this, degree of freedom in design of the dioptric system can be increased, and further, manufacturing cost of the dioptric system can be reduced.

In the light-emitting device of the invention, it is preferable that the dioptric system is a single optical component including the plurality of inclined surfaces.

With this, an area necessary for the dioptric system can be made small, and the size of the light-emitting device can be made small.

In the light-emitting device of the invention, it is preferable that the plurality of inclined surfaces are provided at both of an incident surface and a light exiting surface of the dioptric system, and that the incident surface and the light exiting surface from which a light ray input from the respective incident surface is output are inclined such that a distance therebetween becomes larger as departing from the optical axis of the condensing optical system.

By providing the inclined surfaces to both of the incident surface and the light exiting surface of the dioptric system, degree of refraction for each surface can be made small, and the dioptric system can be formed in a shape easy to design and easy to manufacture.

In the light-emitting device of the invention, it is preferable that optical axes of the plurality of laser light sources, respectively, are in parallel to the optical axis of the condensing optical system.

With this, the plurality of laser light sources can be arranged by a known technique.

In the light-emitting device of the invention, it is preferable that the condensing optical system is made of a single condenser lens.

With this, an area necessary for the condensing optical system can be made small, and the size of the light-emitting device can be made small.

According to the invention, it is possible to condense laser light rays output from a plurality of light sources to be a spot whose diameter is less than or equal to a predetermined size to increase a light intensity per unit area.

### BRIEF DESCRIPTION OF THE DRAWINGS

Fig. 1 is a plan view illustrating a structure of a light-emitting device of a first embodiment of the invention;
Fig. 2 is an elevation view illustrating a structure of a light source unit of the light-emitting device illustrated in Fig. 1;
Fig. 3 is a perspective view illustrating a structure of a prism of the light-emitting device illustrated in Fig. 1;
Fig. 4 is a view illustrating a simulation model of a light-emitting device of example 1 of the first embodiment;
Fig. 5 is a view illustrating a simulation model of a light-emitting device of a comparative example;
Fig. 6 is a view in which (A) indicates a simulation result of the model illustrated in Fig. 4 at a position P11, (B) indicates a simulation result of the model illustrated in Fig. 4 at a position P12, and (C) indicates a simulation result of the model illustrated in Fig. 4 at a position P13;
Fig. 7 is a view in which (A) indicates a simulation result of the model illustrated in Fig. 5 at a position P21, (B) indicates a simulation result of the model illustrated in Fig. 5 at a position P22, and (C) indicates a simulation result of the model illustrated in Fig. 5 at a position P23;
Fig. 8 is an elevation view illustrating a structure of a light source unit of a light-emitting device of a second embodiment of the invention;
Fig. 9-(A) is a perspective view illustrating a structure of a prism of the light-emitting device of the second embodiment; and

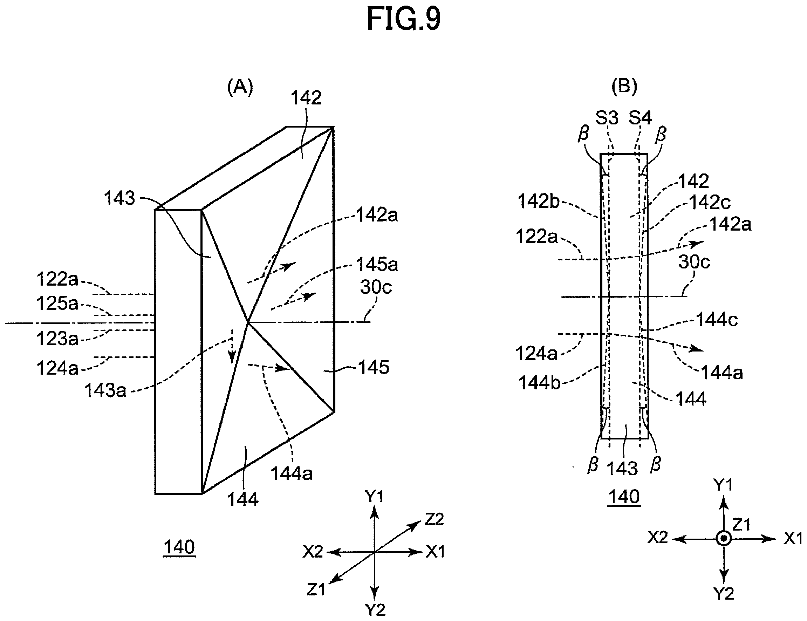

Fig. 9-(B) is a plan view of the prism illustrated in Fig. 9-(A).

### DETAILED DESCRIPTION OF THE PREFERRED EMBODIMENTS

Hereinafter, a light-emitting device of embodiments of the invention is described in detail with reference to drawings.

### (First embodiment)

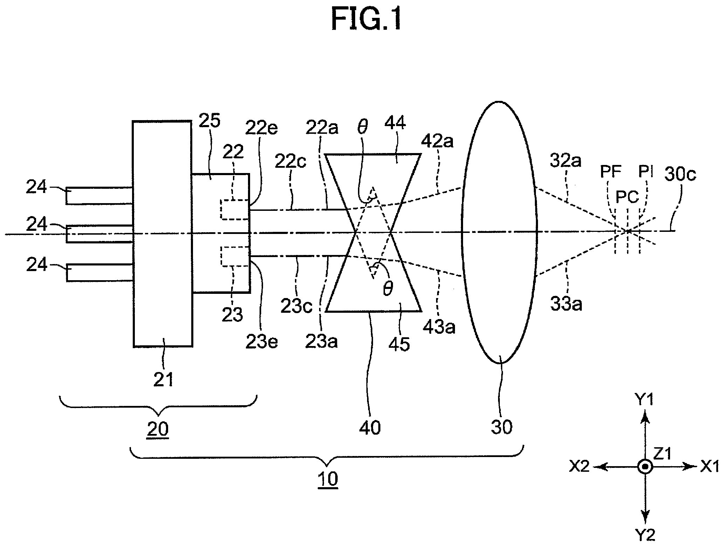

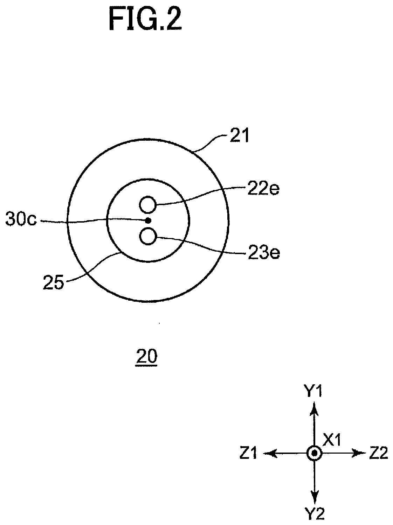

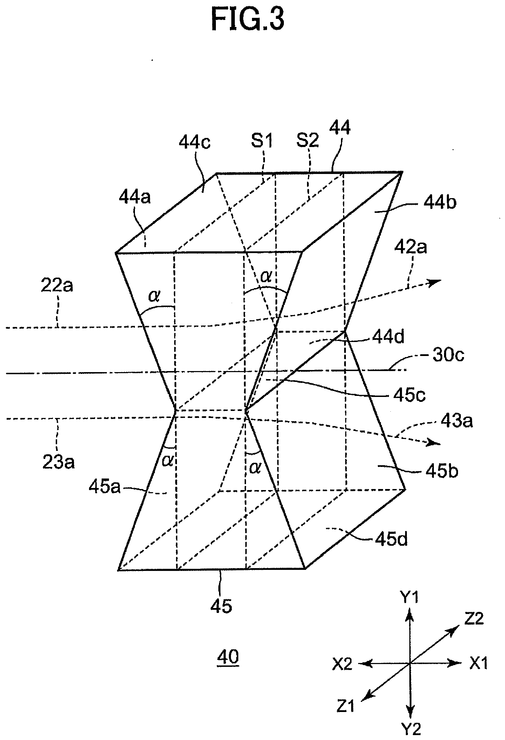

Fig. 1 is a plan view illustrating a structure of a light-emitting device 10 of a first embodiment. Fig. 2 is an elevation view illustrating a structure of a light source unit 20 of the light-emitting device 10. Fig. 3 is a perspective view illustrating a structure of a prism 40 of the light-emitting device 10. In each of the drawings, an X-Y-Z coordinate is illustrated as a standard coordinate. An X1-X2 direction is a direction that extends along an optical axis 30c of a condenser lens 30, and a Y-Z plane is a plane that is perpendicular to the X1-X2 direction.

As illustrated in Fig. 1, the light-emitting device 10 includes the light source unit 20, the condenser lens 30 as a condensing optical system, and a prism 40 as a dioptric system.

In the light source unit 20, two laser diodes 22 and 23 as laser light sources are bonded to a stem 21. Further, a semiconductor chip (not illustrated in the drawings) for driving the laser diodes 22 and 23 and a lead frame (not illustrated in the drawings) for supporting the semiconductor chip are provided at the stem 21. A plurality of terminals 24 connected to the lead frame are extending outside by penetrating the stem 21 in the X2 direction. A hollow metal cap 25 is fixed to the stem 21 so as to cover the lead frame, the semiconductor chip and the laser diodes 22 and 23. Resin is filled in the cap 25, and with this, positions of the laser diodes 22 and 23 are fixed.

As illustrated in Fig. 1 and Fig. 2, for the laser diodes 22 and 23, light exiting surfaces 22e and 23e are provided at a surface (a front end surface in the X1 direction) of the cap 25, respectively. The laser diodes 22 and 23 are provided such that their optical axes 22c and 23c, respectively, are in parallel to the optical axis 30c of the condenser lens 30.

As illustrated in Fig. 1, the condenser lens 30 as the condensing optical system is a double-convex plus lens. Here, as the condensing optical system, it is not limited to the double-convex plus lens as illustrated in Fig. 1, and as long as having a positive refractive power, a lens having another shape may be used. Further, not limited to a single lens, and an optical system in which a plurality of lenses are combined to have a condensing property may be used.

As illustrated in Fig. 1 and Fig. 3, the prism 40 includes two refraction parts 44 and 45 provided at an upper side and a lower side, respectively, in a Y1-Y2 direction. These refraction parts 44 and 45 have shapes that are symmetrical with respect to an XZ-plane. In the prism 40, the two refraction parts 44 and 45 are integrally formed using a glass or a plastic, for example.

The first refraction part 44 of the prism 40 at a Y1 direction side has a bilateral symmetrical trapezoidal shape when seen in a Z1-Z2 direction. Two side surfaces 44c and 44d, corresponding to an upper base and a lower base of the trapezoidal shape, are planes parallel to each other, and extending in the XZ-plane, respectively. An incident surface 44a and a light exiting surface 44b, corresponding to remaining two sides of the trapezoidal shape, are planes each having an inclined angle such that a distance therebetween becomes larger as departing from the optical axis 30c of the condenser lens 30, and provided in this order from a light source unit 20 side in the X1-X2 direction. When the incident surface 44a and the light exiting surface 44b are virtually extended in the Y2 direction, a vertex angle "θ" is formed at a crossing position when seen in the Z1-Z2 direction (Fig. 1). As illustrated in Fig. 3, the incident surface 44a is inclined with respect to a plane S1 that is in parallel to the YZ-plane in an X2 direction side, and the light exiting surface 44b is inclined with respect to a plane S2 that is in parallel to the YZ-plane in an X1 direction side, wherein an inclined angle is "α", respectively. The inclined angle "α" is set in accordance with an arrangement of the laser diode 22 with respect to the optical axis 30c of the condenser lens 30, a refractive index of the first refraction part 44, a refractive power of the condenser lens 30 or the like. In this embodiment, the inclined angle "α" is set to be 1 / 2 of the vertex angle "θ".

The second refraction part 45 of the prism 40 at a Y2 direction side has a bilateral symmetrical trapezoidal shape when seen in the Z1-Z2 direction. Two side surfaces 45c and 45d corresponding to an upper base and a lower base of the trapezoidal shape, are planes parallel to each other, and extending in the XZ-plane, respectively. An incident surface 45a and a light exiting surface 45b, corresponding to remaining two sides of the trapezoidal shape, are planes each having an inclined angle such that a distance therebetween becomes larger as departing from the optical axis 30c of the condenser lens 30, and provided in this order from the light source unit 20 side in the X1-X2 direction. When the incident surface 45a and the light exiting surface 45b are virtually extended in the Y1 direction, a vertex angle "θ" is formed at a crossing position when seen from the Z1-Z2 direction (Fig. 1). This means that the vertex angle formed by the incident surface 45a and the light exiting surface 45b is the same as the vertex angle formed by the incident surface 44a and the light exiting surface 44b. Further, as illustrated in Fig. 3, the incident surface 45a is inclined with respect to the plane S1 in the X2 direction side, and the light exiting surface 45b is inclined with respect to the plane S2 in the X1 direction, wherein an inclined angle is "α", respectively. These inclined angles are set in accordance with an arrangement of the laser diode 23 with respect to the optical axis 30c of the condenser lens 30, a refractive index of the second refraction part 45, the refractive power of the condenser lens 30 or the like. In this embodiment, this angle is the same as the inclined angle of the incident surface 44a and the light exiting surface 44b of the first refraction part 44.

In the prism 40, the side surface 44d of the first refraction part 44 and the side surface 45c of the second refraction part 45 are formed to be a common surface (shared surface), and as illustrated in Fig. 3, the common surface is provided at the XZ-plane including the optical axis 30c of the condenser lens 30. With this, the first refraction part 44 and the second refraction part 45 are provided to be symmetrical with respect to the XZ-plane.

In the light-emitting device 10 having the above described structure, a center light beam 22a of an outgoing light ray from the laser diode 22 is input in the incident surface 44a in parallel to the optical axis 30c, and a center light beam 23a of an outgoing light ray from the laser diode 23 is input in the incident surface 45a in parallel to the optical axis 30c as well.

The center light beam 22a is refracted in the first refraction part 44 in accordance with the refractive index of the first refraction part 44 and the setting of the inclined angle "α" of the incident surface 44a and the light exiting surface 44b to be output from the light exiting surface 44b. As such, the refracted light ray 42a output from the light exiting surface 44b proceeds such that to depart from the optical axis 30c of the condenser lens 30 as proceeding toward a condenser lens 30 side.

Further, the center light beam 23a is refracted in the second refraction part 45 in accordance with the refractive index of the second refraction part 45, and the setting of the inclined angle "α" of the incident surface 45a and the light exiting surface 45b to be output from the light exiting surface 45b. The refracted light ray 43a output from the light exiting surface 45b proceeds such that to depart from the optical axis 30c of the condenser lens 30 as proceeding toward the condenser lens 30 side.

Thus, the refracted light ray 42a and the refracted light ray 43a proceed to depart from each other as proceeding toward the condenser lens 30 side.

As illustrated in Fig. 1, the refracted light rays 42a and 43a output from the prism 40 are output from the condenser lens 30 as converging light rays 32a and 33a, respectively. Light fluxes of these converging light rays 32a and 33a overlap and become a pinpoint spot at a condensing position PC, and thereafter, images are formed at an image formation position PI, respectively. Thus, as the two light fluxes are overlapped to form the spot having a pinpoint diameter with a high light intensity at the condensing position PC, a light intensity per unit area can be increased at this position, and high-power can be obtained. Here, the light intensity of the spot formed at the condensing position PC is approximately two times of each of the laser light rays output from the laser diodes 22 and 23, respectively. Further, the condensing position PC is positioned at a back side of a back focal position PF of the condenser lens 30, in other words at a proceeded position of an image-side focal point in the X1 direction.

On the other hand, if the laser light rays output from the laser diodes 22 and 23 are directly input in the condenser lens 30 without using the prism 40, light fluxes are not overlapped at the back side of the back focal position PF to form a spot. Further, in such a case, portions of the two light fluxes may be overlapped at a front side of the back focal position PF, but the light fluxes do not form a spot at the position, and there exist portions where the light fluxes are overlapped and portions where the light fluxes are not overlapped. Thus, a light intensity per unit area is uneven, and the maximum value of the light intensity per unit area is approximately 1 to 1.5 times of a case when a single laser light is used.

Next, an example of the first embodiment is described.

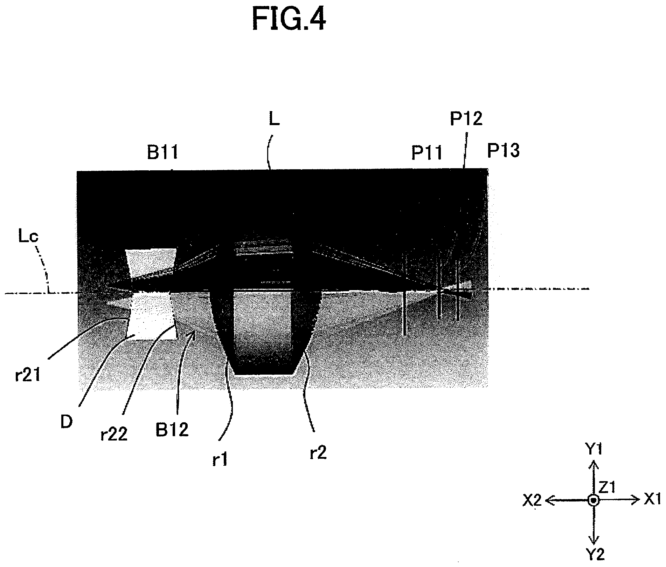

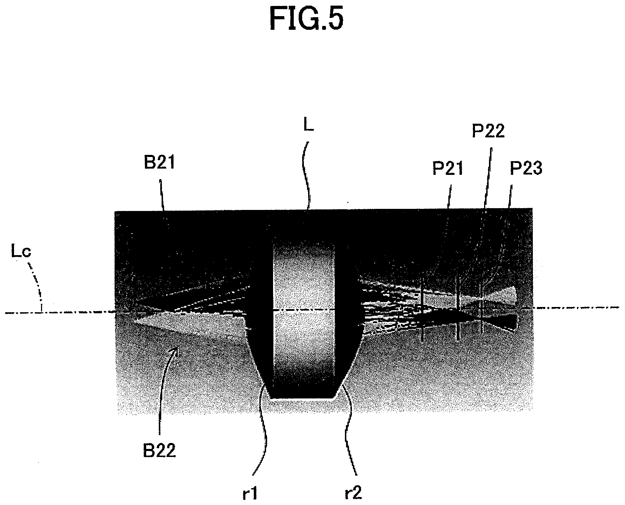

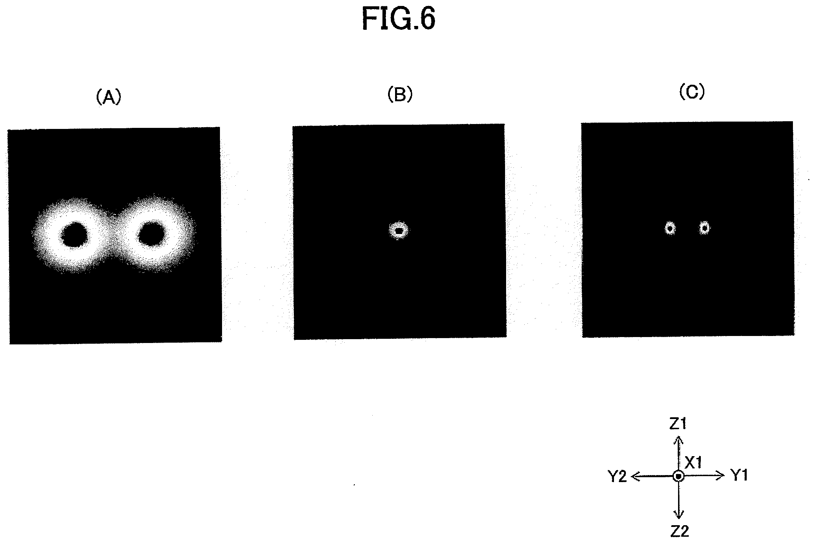

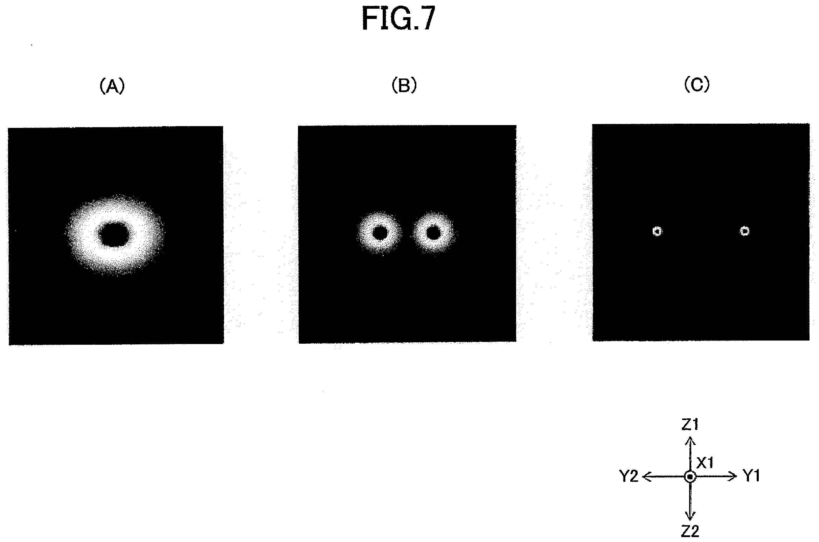

Fig. 4 is a view illustrating a simulation model of a light-emitting device of example 1 of the first embodiment. Fig. 5 is a view illustrating a simulation model of a light-emitting device of a comparative example. Each of Fig. 4 and Fig. 5 illustrates a lens L corresponding to the condenser lens 30 of Fig. 1, and an optical path in which light rays output from two laser diodes proceed from a left-side to a right-side. In Fig. 4, a prism D corresponding to the prism 40 of Fig. 1 is illustrated. (A), (B) and (C) of Fig. 6 illustrate simulation results at positions P11, P12 and P13, respectively, in the model of example 1 illustrated in Fig. 4. (A), (B) and (C) of Fig. 7 illustrate simulation results at positions P21, P22 and P23, respectively, in the model of the comparative example illustrated in Fig. 5. Here, the position P11 of Fig. 4 and the position P21 of Fig. 5 correspond to the back focal position PF in Fig. 1, the position P12 of Fig. 4 and the position P22 of Fig. 5 correspond to the condensing position PC in Fig. 1, and the position P13 of Fig. 4 and the position P23 of Fig. 5 correspond to the image formation position PI in Fig. 1.

In example 1 illustrated in Fig. 4, light rays B11 and B12 are output from two laser diodes under the following conditions. In the comparative example illustrated in Fig. 5, light rays B21 and B22 are output from two laser diodes, and a simulation was conducted under the same conditions as example 1 except that the prism D is not provided. Here, an output of the laser diode was 1 W (watt) for both example 1 and the comparative example.

### (Example 1)

Each of the following distances is a distance in a direction along an axis Lc of the lens L, and an axial distance means a distance on the optical axis Lc.

### (Characteristics of laser diode)

Light emitting positions: 0.2 mm from the optical axis Lc of the lens L in the Y1 direction, and 0.2 mm from the optical axis Lc of the lens L in the Y2 direction
Light emitting angle: 0 degree with respect to the optical axis Lc of the lens L
Angle of divergence: ± 10 degrees with having an optical axis of a laser diode as a center

### (Characteristics of prism D)

Material: BK7 (product name, borosilicate crown glass, refractive index 1.517, Abbe number 64.2)
Inclined angle "α" of the incident surface and the light exiting surface: 10 degrees
Thickness in the Z1-Z2 direction (a center portion of the XY-plane): 0.9 mm
Distance from a light exiting surface of the laser diode to an incident surface r21 of the prism D: 0.5 mm

### (Characteristics of lens L)

Focal length: 1.65 mm
Radius of curvature R at a front surface r1 (light source side surface): 2.1
Radius of curvature R at a back surface r2 (image-side surface): 1.8
Lens thickness: 2.5 mm
Aperture diameter: diameter 3.6 mm
Axial distance from the light exiting surface r22 of the prism D to the front surface r1 of the lens L: 1.4 mm
Axial distance from the back surface r2 of the lens L to the image formation position P13: 5.0 mm

The following results were obtained by the simulations.

In example 1, as illustrated in (B) of Fig. 6, a single spot was formed at the condensing position P12, the spot diameter was 0.15 mm, and the maximum value of the light intensity per unit area (hereinafter, referred to as "Emax") was 40000 W / cm². Meanwhile, Emax of the two light fluxes at the back focal position P11 in (A) of Fig. 6 was 1700 W / cm².

On the other hand, as illustrated in (B) of Fig. 7, in the comparative example, a single spot was formed at the condensing position P22, and Emax of the two light fluxes at the condensing position P22 was 8000 W / cm². Further, Emax of the two light fluxes at the back focal position P21 in (A) of Fig. 7 was 1800 W / cm².

From the above results, compared with the comparative example in which the outgoing light rays from the laser diodes were directly input in the lens L, in example 1 in which the prism D was provided between the laser diodes and the lens L, the light fluxes were overlapped to be a small spot at the condensing position P12, and the light intensity was increased. This light intensity was higher than the light intensity at the back focal position P21 in the comparative example.

Alternative examples are described in the following.

In the above described embodiment, both of the incident surface and the light exiting surface of each of the first refraction part 44 and the second refraction part 45 of the prism 40 are formed to be the inclined surfaces, respectively. However, as long as the plurality of outgoing light rays from the first refraction part 44 and the second refraction part 45 can proceed such that a distance therebetween becomes larger as proceeding toward the condenser lens 30 side, only one of the incident surface and the light exiting surface may be formed to be the inclined surface. Further, even for a case where both of the incident surface and the light exiting surface are formed to be the inclined surfaces, respectively, as long as the plurality of outgoing light rays from the first refraction part 44 and the second refraction part 45 can proceed such that a distance therebetween becomes larger as proceeding toward the condenser lens 30 side, the inclined angles may be different for the incident surface and the light exiting surface. Further, the inclined surface is not limited to a plane, and may be an aspheric surface or a hemispherical curved surface, or only an input area from each of the laser diodes 22 and 23 and an output area from the prism 40 may be configured by a desired inclined surface or a curved surface.

When three or more of the laser diodes are provided in series in the Y1-Y2 direction, inclined angles of the inclined surfaces of areas of the prism 40 at which the outgoing light rays from the laser diodes are varied in accordance with distances from the optical axis 30c of the condenser lens 30 in the Y1-Y2 direction, respectively, so that the outgoing light rays from the condenser lens 30 can be condensed as a spot at the condensing position PC. This is the same for a case when laser diodes are aligned in series in a direction other than the Y1-Y2 direction.

In the above described embodiment, the single prism 40 is used as the dioptric system. However, as long as refracted light rays can be generated from the outgoing light rays from the laser diodes 22 and 23, respectively, similarly by the prism 40, another configuration may be used. For example, an optical member in which the outgoing light ray from the laser diode 22 is input, and an optical member in which the outgoing light ray from the laser diode 23 is input, may be separately provided.

In the above described embodiment, the two laser diodes 22 and 23 are provided such that their optical axes are in parallel to each other. However, as long as a desired spot can be formed by converging light rays output from the condenser lens 30, the optical axes of the laser diodes 22 and 23 may be inclined by a predetermined angle with respect to the optical axis 30c of the condenser lens 30, respectively.

According to the light-emitting device of the first embodiment and its alternative examples, as configured as above description, following effects can be obtained.
(1) By refracting each of the outgoing light rays from the laser diodes 22 and 23 by using the prism 40, the plurality of converging light rays output from the condenser lens 30 can be overlapped and condensed to be a small spot. Thus, light whose light intensity per unit area is large can be obtained.
(2) As the first refraction part 44 and the second refraction part 45 are formed to have shapes symmetrical with respect to the XZ-plane, the spot formed by overlapping the converging light rays 32a and 33a output from the condenser lens 30 becomes smaller and nearly a circular shape. Thus, the light intensity can be furthermore increased.
(3) In order to input a plurality of light beams that proceed to depart from each other to the condenser lens 30, the configuration as the light-emitting device of the first embodiment in which the prism 40 as the dioptric system is provided between the laser diodes 22 and 23 and the condenser lens 30 is considered. Aside from this configuration, without using the dioptric system, a configuration in which a direction of an outgoing light ray from each of the plurality of laser diodes is inclined with respect to the optical axis 30c of the condenser lens 30 may be considered. However, It is very difficult to accurately set inclined angles of all of the laser diodes to a degree that the plurality of outgoing light rays from the condenser lens 30 can be condensed to be a small spot. On the other hand, according to the light-emitting device of the first embodiment, as the prism 40 is used, it is only necessary to provide the laser diodes 22 and 23 to be in parallel to each other, and a plurality of outgoing light rays from the condenser lens 30 can be accurately condensed at a desired position as a small spot.

### (Second embodiment)

Next, a second embodiment of the invention is described. In the second embodiment, the number of laser diodes, as the laser light sources, are four. In the following description, the same components as those described in the first embodiment are given the same reference numerals.

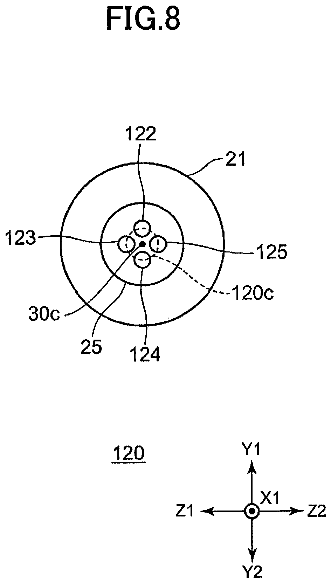

Fig. 8 is an elevation view illustrating a structure of a light source unit 120 of a light-emitting device of a second embodiment. Fig. 9-(A) is a perspective view illustrating a structure of a prism 140 of the light-emitting device of the second embodiment, and Fig. 9-(B) is a plan view of the prism 140 illustrated in Fig. 9-(A). In Fig. 9-(B), center light beams 123a and 125a, and refracted light rays 143a and 145a are not illustrated.

As illustrated in Fig. 8, in the second embodiment, four laser diodes 122, 123, 124 and 125 are provided as laser light sources such that each optical axis is positioned on a circle 120c whose center is the optical axis 30c of the condenser lens 30, and these laser diodes are bonded to the stem 21. Each optical axis of each of the laser diodes 122, 123, 124 and 125 is in parallel to the optical axis 30c of the condenser lens 30, similarly as the first embodiment. The laser diode 122 is provided at the Y1 direction side, the laser diode 123 is provided at the Z1 direction side, the laser diode 124 is provided at the Y2 direction side, and the laser diode 125 is provided at the Z2 side, with respect to the optical axis 30c.

In the second embodiment, instead of the prism 40 of the first embodiment, the prism 140 illustrated in Fig. 9-(A) and Fig. 9-(B) is used as the dioptric system. As illustrated in Fig. 9-(A), the prism 140 has a rectangular outer shape when seen in the X1-X2 direction, and four refraction parts 142, 143, 144 and 145 are provided to correspond to the four laser diodes 122, 123, 124 and 125, respectively. More specifically, the refraction part 142 is provided at the Y1 direction side, the refraction part 143 is provided at the Z1 direction side, the refraction part 144 is provided at the Y2 direction, and the refraction part 145 is provided at the Z2, with respect to the optical axis 30c, with equiangular intervals. The four refraction parts 142, 143, 144 and 145 are integrally formed by using a glass or a plastic, for example.

Each of the refraction parts 142, 143, 144 and 145 includes an incident surface to which an outgoing light ray from the respective laser diode 122, 123, 124 or 125 is input, and a light exiting surface from which the input light ray is output after being refracted, from the light source unit 120 side in this order in the X1-X2 direction. The incident surface and the light exiting surface of the same refraction part are planes including inclined angles such that a distance therebetween becomes larger as departing from the optical axis 30c of the condenser lens 30. For example, as illustrated in Fig. 9-(B), an incident surface 142b and a light exiting surface 142c are provided in the refraction part 142, and an incident surface 144b and a light exiting surface 144c are provided in the refraction part 144. In the refraction part 142, the incident surface 142b is inclined toward the X2 direction side with respect to a plane S3 that is in parallel to the YZ-plane, the light exiting surface 142c is inclined toward the X1 direction side with respect to a plane S4 that is in parallel to the YZ-plane, and each inclined angle is "α". Further, in the refraction part 144, the incident surface 144b is inclined toward the X2 direction side with respect to the plane S3, the light exiting surface 144c is inclined toward the X1 direction side with respect to the plane S4, and each inclined angle is "α". Such a structure is the same for each of the refraction parts 143 and 145.

In the prism 140 having the structure as described above, the outgoing light rays (center light beams 122a, 123a, 124a and 125a) from the laser diodes 122, 123, 124 and 125 are input in the refraction parts 142, 143, 144 and 145, and refracted to be output to the condenser lens 30 as refracted light rays 142a, 143a, 144a and 145a, respectively. These refracted light rays proceed such that to depart from the optical axis 30c of the condenser lens 30 as proceeding toward the condenser lens 30 side and are input in the condenser lens 30, and light fluxes of the converging light rays condensed by the condenser lens 30 overlap at the condensing position PC to become a pinpoint spot.

Here, although a planar shape of the prism 140 seen in the X1-X2 direction is configured to have a rectangular shape, as long as input areas from the laser diodes 122, 123, 124 and 125 and output areas of the refracted light rays, respectively, can be ensured, a shape other than the rectangular shape, for example, a circular shape may be used.

Here, other functions, effects and alternative examples are the same as those of the first embodiment.

Although the present invention has been illustrated and described with reference to the embodiments, it is to be understood that modifications may be made therein without departing from the spirit and scope of the invention as defined by the claims.

As described above, as it is possible to obtain a spot light flux with a high light intensity at a condensing position according to the light-emitting device of the embodiment, it is usable for light working or illumination.
- 10: light-emitting device
- 20: light source unit
- 22a, 23a: center light beam
- 22c, 23c: optical axis
- 22e, 23e: light exiting surface
- 22, 23: laser diode
- 30: condenser lens (condensing optical system)
- 30c: optical axis
- 32a, 33a: converging light ray
- 40: prism (dioptric system)
- 42a, 43a: refracted light ray
- 44: first refraction part
- 44a: incident surface
- 44b: light exiting surface
- 45: second refraction part
- 45a: incident surface
- 45b: light exiting surface
- 120: light source unit
- 122, 123, 124, 125: laser diode
- 122a, 123a, 124a, 125a: center light beam
- 140: prism (dioptric system)
- 142, 143, 144, 145: refraction part
- 142a, 143a, 144a, 145a: refracted light ray
- 142b, 144b: incident surface
- 142c, 144c: light exiting surface
- D: prism (dioptric system)
- L: lens (condensing optical system)
- Lc: optical axis
- PF, P11, P21: back focal position
- PC, P12, P22: condensing position
- PI, P13, P23: image formation position
- r1: front surface
- r21: incident surface
- r2: back surface
- r22: light exiting surface

## Claims

1. A light-emitting device comprising:
a light source unit including a plurality of laser light sources;
a dioptric system that refracts each light ray input from each of the plurality of laser light sources;
a condensing optical system that condenses a plurality of refracted light rays input from the dioptric system, respectively,
wherein the dioptric system is configured to refract a plurality of center light beams that are output along optical axes of the plurality of laser light sources, respectively, to proceed in directions each departing from an optical axis of the condensing optical system as proceeding toward the condensing optical system.

2. The light-emitting device according to claim 1, wherein the dioptric system includes a plurality of inclined surfaces each having an inclined angle corresponding to each of the plurality of laser light sources.

3. The light-emitting device according to claim 2, wherein the plurality of inclined surfaces are provided at at least one of an incident surface and a light exiting surface of the dioptric system.

4. The light-emitting device according to claim 2 or 3, wherein the dioptric system is a single optical component including the plurality of inclined surfaces.

5. The light-emitting device according to claim 4,
wherein the plurality of inclined surfaces are provided at both of an incident surface and a light exiting surface of the dioptric system, and
wherein the incident surface and the light exiting surface from which a light ray input from the respective incident surface is output are inclined such that a distance therebetween becomes larger as departing from the optical axis of the condensing optical system.

6. The light-emitting device according to claim 1, wherein optical axes of the plurality of laser light sources, respectively, are in parallel to the optical axis of the condensing optical system.

7. The light-emitting device according to any one of claims 1 to 6, wherein the condensing optical system is made of a single condenser lens.
